# EUROPÄISCHE PATENTSCHRIFT

(11) **EP 1 429 385 B1**
(45) Veröffentlichungstag und Bekanntmachung des Hinweises auf die Patenterteilung: **21.09.2011**
(21) Anmeldenummer: 03027136.5
(22) Anmeldetag: 26.11.2003
(51) Int. Cl.: H01L 23/053, H01L 23/498, H01L 25/07

(54) **Gehäuse für Leistungshalbleitermodule**
Housing for power semiconductor modules
Boîtier pour modules semiconducteurs de puissance

(30) Priorität: 14.12.2002 DE 10258570
(43) Veröffentlichungstag der Anmeldung: 16.06.2004
(73) Patentinhaber: SEMIKRON Elektronik GmbH & Co. KG, 90431 Nürnberg (DE)
(72) Erfinder: Kroneder, Christian, 90596 Schwanstetten (DE)

(56) Entgegenhaltungen:
- EP-A- 0 513 410
- DE-A- 19 719 703
- PATENT ABSTRACTS OF JAPAN vol. 1995, no. 09, 31. Oktober 1995 (1995-10-31) & JP 07 153906 A (SANSHA ELECTRIC MFG CO LTD), 16. Juni 1995 (1995-06-16)

## Beschreibung

Die Erfindung beschreibt ein Gehäuse für Leistungshalbleitermodule mit Grundplatte oder zur direkten Montage auf einem Kühlkörper. Derartige Leistungshalbleitermodule bestehen nach dem Stand der Technik aus einem Gehäuse mit Anschlusselementen und einem Substrat mit schaltungsgerecht darauf angeordneten und verbundenen Leistungshalbleiterbauelementen wie Thyristoren und / oder Dioden, aber auch Leistungstransistoren wie MOSFETs oder Insulated- Gate- Bipolar- Transistoren (IGBT) mit antiparallel dazu geschalteten Freilaufdioden.

Der Ausgangspunkt der Erfindung sind daher moderne Leistungshalbleitermodule wie sie beispielhaft aus der EP 0 750 345 A2 bekannt sind. Diese Leistungshalbleitermodule bestehen unter besonderer Berücksichtigung der für diese Erfindung wesentlichen Komponenten aus:
- Einem Boden des Leistungshalbleitermoduls, der entweder aus einer Grundplatte mit darauf angeordnetem Substrat oder ausschließlich einem Substrat besteht.
- Einem Substrat, das schaltungsgerecht strukturierte Verbindungsbahnen aufweist, auf denen Leistungshalbleiter- und andere Bauelement angeordnet sind.
- Einem zumindest teilweise rahmenartigen Gehäuse, welches das Substrat umschließt und in welches die Anschlusselemente zur elektrischen Verbindung der Bauelemente bzw. des Substrats mit externen Zuleitungen eingebettet sind.
- Einem Deckel als oberen Abschluss des Leistungshalbleitermoduls.

Anschlusselemente in Leistungshalbleitermodulen haben im Wesentlichen zwei unterschiedliche Aufgaben, einerseits die Verbindung der externen Laststromzuleitungen mit den Leistungshalbleiterbauelementen und andererseits die Verbindung externer Steuer- und / oder Hilfsanschlüsse zur Steuerung der Leistungshalbleiterbauelemente, zur Verbindung mit Sensoren innerhalb des Leistungshalbleitermoduls oder zur Verbindung mit weiteren Bauelementen innerhalb des Leistungshalbleitermoduls. Anschlussleiter für Lastströme weisen vorzugsweise Schraubverbindungen zu den externen Zuleitungen auf, während die externen Steuer- und / oder Hilfsanschlüsse vorzugsweise als Steckkontakte ausgebildet sind. Im Inneren des Leistungshalbleitermoduls bilden nach dem Stand der Technik häufig Drahtbondverbindungen den elektrischen Kontakt zwischen den Anschlusselementen und den Verbindungsbahnen des Substrats, auf denen die Bauelemente angeordnet sind. Zur Drahtbondverbindung weisen die Anschlusselemente vorzugsweise parallel zum Substrat ausgerichtete nicht vom Gehäuse umschlossene Teilflächen auf.

Derartige Anschlussleiter sind ebenfalls in der DE 43 25 942 C2 offenbart. Hierin wird vorgeschlagen die Anschlussleiter in ihrem Verlauf innerhalb der Gehäuses mehrfach unter einem Winkel kleiner 90 Grad abzuwinkeln, um eine höhere Stabilität der Verbindung der in das Gehäuse eingespritzten Anschlussleiter gegen beim Drahtbonden auftretende Schwingungen zu erreichen.

Nachteilig am Stand der Technik ist, dass in den genannten Druckschriften die Anschlusselemente in das Gehäuse eingespritzt sind. Dies bewirkt einerseits, dass für unterschiedliche Konfigurationen der Anschlusselemente eine Mehrzahl von Gehäusevarianten vorgehalten werden müssen. Andererseits schrumpft der Kunststoff während der Abkühlphase seiner Herstellung. Daraus resultiert eine nicht genügende Festigkeit der Verankerung der metallischen Anschlusselemente im Kunststoff. Diese Festigkeit ist allerdings maßgeblich für die Qualität der Drahtbondverbindung zwischen der Teilfläche des Anschlusselementes und den Verbindungsbahnen des Substrates, weil das Drahtbonden durch die dafür charakteristischen Schwingungen stabil gelagerte Flächen benötigt

Weiterhin zählt zum Stand der Technik die DE 197 19 703 A1, die vorschlägt die Anschusselementen eines Leistungshalbleitermoduls in das rahmenartige Gehäuse einzupressen und hierzu die Ausgestaltung offen läßt. Die EP 0 513 410 A1 zählt ebenfalls zum erweiterten Stand der Technik. Hier werden Anschlusselemente für Lötanschlüsse in Anformungen des Gehäuses positioniert um das Gehäuse gleichzeitig als Lötform für die Verbindung der Anschlusselemente mit den Leistungshalbleiterbauelementen und / oder dem Substrat zu verwenden. Die JP 07 153906 A offenbart ein Anschlusselement, das in seinem Verlauf eine Einschnürung aufweist, wobei diese Einschnürung der Einbringung des Anschlusselementes durch eine Ausnehmung der Halteeinrichtung des Anschlusselements dient. Hierbei ist die Halteeinrichtung Bestandteil des Gehäuses. Zusätzlich weist das Gehäuse noch eine Abstützkante für das Anschlusselement auf.

Der vorliegenden Erfindung liegt die Aufgabe zu Grunde ein Gehäuse für Leistungshalbleitermodule vorzustellen, wobei die Anschlusselemente bei minimaler Beweglichkeit auf das Substrat zu und von dem Substrat weg dauerhaft haltbar in dem Gehäuse fixiert werden und wobei das Gehäuse flexibel mit Anschlusselementen bestückt werden kann.

Diese Aufgabe wird gelöst durch eine Schaltungsanordnung nach dem Anspruch 1, spezielle Ausgestaltungen finden sich in den Unteransprüchen.

Die erfinderische Weiterbildung eines dem Stand der Technik entsprechenden Gehäuses für Leistungshalbleitermodule mit Grundplatte oder zur direkten Montage auf einem Kühlkörper wird im folgenden beschrieben. Das Gehäuse umschließt mindestens ein elektrisch isolierendes Substrat mit darauf angeordneten gegeneinander isolierten metallischen Verbindungsbahnen mit darauf angeordneten Leistungshalbleiterbauelementen. Dieses Gehäuse besteht aus einer Mehrzahl von Teilen, mindestens einem Deckel sowie mindestens einem rahmenartigen, die Seitenwände bildenden Gehäuseteil. Erfinderisch ist nun, dass dieses rahmenartige Gehäuseteil seinerseits aus mindestens einem Hauptrahmen sowie mindestens einem Arretierrahmen besteht. Der Hauptrahmen weist Führungen zur Aufnahme von Anschlusselementen auf, wobei diese Anschlusselemente substratseitig mindestens eine Teilfläche als Anschlusslasche parallel zum Substrat verlaufend aufweisen. Weiterhin weise diese Anschlusselemente mindestens eine Anschlagfläche auf, die an Widerlagern des Hauptrahmens anliegen, um eine Bewegung des Anschlusselementes in Richtung von dem Substrat weg zu verhindern. Mindestens ein Arretierrahmen ist derartig zum Hauptrahmen angeordnet, dass der Arretierrahmen zumindest teilweise auf den Anschlusslaschen der Anschlusselemente aufliegt, um eine Bewegung der Anschlusselemente in Richtung auf das Substrat hin zu verhindern.

Durch diese Ausbildung des Gehäuses eines Leistungshalbleitermoduls ist, unabhängig vom Herstellungsverfahren des Gehäuses selbst, gewährleistet, dass die Anschlusselemente mechanisch stabil innerhalb des Gehäuses fixiert sind. Weiterhin vorteilhaft an dieser erfinderischen Ausgestaltung des Gehäuses ist, dass nur diejenigen Führungen des Hauptrahmens mit Anschlussleitem bestückt werden können, die auch für die jeweilige auf dem Substrat befindliche Schaltungsanordnung erforderlich ist. Somit können mit einem Gehäuse Leistungshalbleiterbauelemente unterschiedlicher Funktionalität hergestellt werden.

Vorteilhaft ist weiterhin, dass der Arretierrahmen als Abstützung der Anschlusslaschen, der Teilflächen der Anschlussleiter im Inneren des Gehäuses, von welchen die Drahtbondverbindungen zu den Verbindungsbahnen des Substrates oder den Halbleiterbauelementen ausgehen, dient. Dies ist vorteilhaft, da somit den beim Herstellen der Drahtbondverbindung auf die Anschlusslaschen einwirkenden Kräfte in Richtung des Substrates eine Gegenkraft entgegengestellt wird. Somit gestattet das erfinderische Gehäuse eine flexible Gestaltung bei gleichzeitiger mechanischer Stabilität der Position der Anschlusselemente.

Die Erfindung wird anhand eines Ausführungsbeispiels in Verbindung mit den Fig. 1 bis 3 näher erläutert.
- Fig. 1: zeigt ein Leistungshalbleitermodul mit einem erfindungsgemäßen Gehäuse in schräger Draufsicht.
- Fig. 2: zeigt einen Schnitt entlang der Längsseite des erfindungsgemäßen Gehäuses nach Fig. 1.
- Fig. 3: zeigt eine Explosionszeichnung des erfindungsgemäßen Gehäuses nach Fig. 1

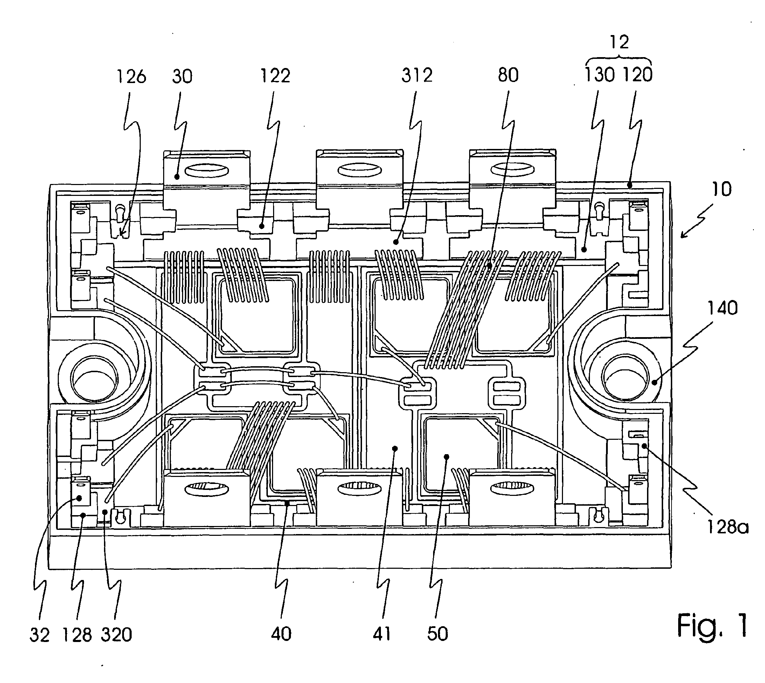

Fig. 1 zeigt ein Leistungshalbleitermodul mit einem erfindungsgemäßen Gehäuse in schräger Draufsicht. Das Gehäuse (12) umschließt hier zwei Substrate (40) mit darauf angeordneten schaltungsgerecht strukturierten metallisierten Flächen. Diese dienen als Verbindungsbahnen (41) und sind mit darauf angeordneten Leistungshalbleiterbauelementen (50) mittels Lötung verbunden. Weiterhin weist dieses Leistungshalbleiterbauelement Drahtbondverbindungen (80), die aus Gründen der Übersichtlichkeit nur zum Teil gezeichnet sind, zur elektrischen Kontaktierung der Leistungshalbleiterbauelemente und / oder der Verbindungsbahnen mit den Anschlusselementen (30, 32) auf. Diese Anschlusselemente dienen dem externen Anschluss des Leistungshalbleitermoduls. Hierzu weist dieses Lastanschlusselemente (30) sowie Hilfs- und Steueranschlusselemente (32) auf. Das Gehäuse weist weiterhin zwei Ausnehmungen (140) zur Schraubverbindung mit einem Kühlkörper auf.

Das Gehäuse (10) weist in erfinderischer Weise einen rahmenartigen Teil (12) auf, der seinerseits aus einem Hauptrahmen (120) sowie zwei Arretierrahmen (130) besteht. Der Hauptrahmen (120) weist Führungen (122, 128) zur Positionierung der Anschlusselemente (30, 32) auf. Auf beiden Längsseiten befinden sich jeweils drei Führungen (122) für die Lastanschlusselemente (30), die an ihrem dem Substrat (40) zugewandten Ende jeweils eine Anschlusslasche (310) zur Anordnung von Bonddrähten (80) zur Verbindung mit den Leistungshalbleiterbauelementen (50) und / oder den Verbindungsbahnen (41) aufweisen. Diese Anschlusslaschen (310) liegen auf dem Arretierrahmen (130) auf, um bei der Herstellung der Drahtbondverbindungen (80) ein mechanisch stabile Position der Anschlusslaschen (310) zu gewährleisten. Weiterhin ist dieser Arretierrahmen (130) mittels auf ihm angeordneter Nasen mit zugeordneten Ausnehmungen (126) des Hauptrahmens (120) verbunden und liegt wie dieser auf der Grundplatte auf. Bei der gegebenen Schaltungstopologie sind alle Führungen (122) für Lastanschlüsse (30) bestückt. Für andere Schaltungstopologien kann, falls diese es ermöglichen, eine oder eine Mehrzahl von Führungen (122) nicht bestückt sein.

Auf den beiden Schmalseiten des Gehäuses (10) befinden sich jeweils vier Führungen (128) für Hilfs- und Steueranschlusselemente (32), die ebenfalls an ihrem dem Substrat (40) zugewandten Ende jeweils eine Anschlusslasche (320) zur Anordnung von Bonddrähten (80) zur Verbindung mit den Leistungshalbleiterbauelementen (50) und / oder den Verbindungsbahnen (41) aufweisen. Diese Anschlusslaschen (320) liegen ebenfalls auf dem Arretierrahmen (130) auf. Bei der dargestellten Schaltungstopologie sind sechs Hilfs- bzw. Steueranschlusselemente notwendig und daher sind zwei Führungen (128a) nicht mit Hilfs- und Steueranschlusselementen (32) bestückt.

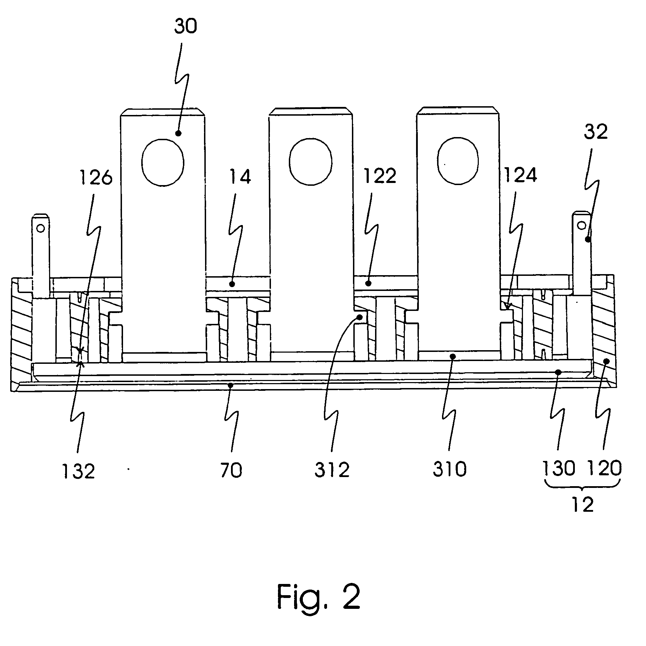

Fig. 2 zeigt einen Schnitt durch den Hauptrahmen entlang der Längsseite des erfindungsgemäßen Gehäuses nach Fig. 1. Das gesamte Gehäuse (10) wird gebildet durch den Deckel (14), einen rahmenartigen Gehäuseteil (12), der seinerseits aus dem Hauptrahmen (120) sowie den Arretierrahmen (130) gebildet wird. Den unteren Abschluss des Leistungshalbleitermoduls bildet die Grundplatte (70). Der Hauptrahmen (120) ist teilweise auf der Grundplatte (70) angeordnet und weist einen Überstand auf, der die Grundplatte umschließt. Weiterhin weist der Hauptrahmen (120) Führungen (122) zur Positionierung der Lastanschlusselemente (30) auf. In diesen Führungen sind Widerlager (124) als Anschläge für die Anschlagflächen (312) der Lastanschlusselemente (30) angeordnet. Dadurch ist gewährleistet, dass eine Bewegung der Lastanschlusselemente in Richtung von der Grundplatte bzw. dem Substrat weg verhindert wird.

Dargestellt ist weiterhin ein Arretierrahmen (130). Dieser ist mittels auf ihm angeordneter Nasen (132) mit zugeordneten Ausnehmungen (126) des Hauptrahmens (120) mit diesem flächig verbunden. Alternativ kann die Verbindung zwischen dem Hauptrahmen (120) und den Hilfsrahmen (130) auch mit einer Verklebung erfolgen.

Der Arretierrahmen (130) liegt auf der Grundplatte (70) ebenfalls flächig auf. Die Anschlusslaschen (310) der Lastanschlusselemente (30) liegen auf der dem Substrat bzw. der Grundplatte abgewandten Seite des Arretierrahmens (130) auf und gewährleisten damit, dass eine Bewegung der Lastanschlusselemente in Richtung auf die Grundplatte bzw. das Substrat verhindert wird.

Die Hilfs- bzw. Steueranschlusselemente (32) werden auf analoge Weise mittels des Haupt-(120) sowie des Arretierrahmens (130) fixiert.

Durch die Verbindung des Hauptrahmens (120) mit dem Arretierrahmen (130) ist somit eine beim Drahtbonden mechanisch belastbare Anordnung des Gehäuses (10) mit darin angeordneten Anschlusselementen (30, 32) auf der Grundplatte (70) geschaffen.

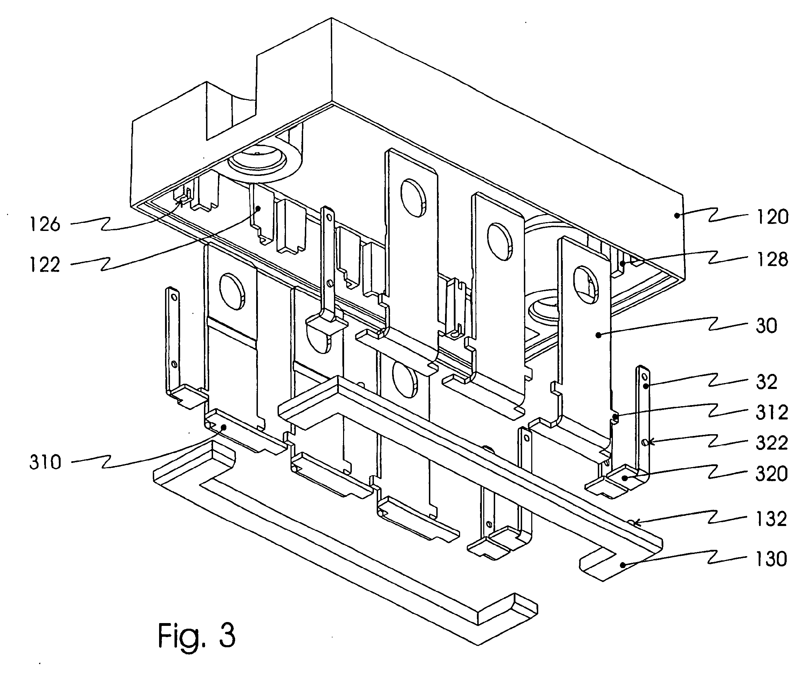

Fig. 3 zeigt eine Explosionszeichnung des erfindungsgemäßen Gehäuses nach Fig. 1. Dargestellt ist der Hauptrahmen (120) mit in seinem Inneren angeordneten Führungen (122) für Lastanschlusselemente (30) sowie Führungen (128) für Hilfs- bzw. Steueranschlusselemente (32). Innerhalb der Führungen (30) sind weiterhin Widerlager (124) angeordnet, die als Anschlag für die beiden Anschlagflächen (312) der Lastanschlusselemente (30) dienen und nach der Montage eine Bewegung dieser in Richtung von der Grundplatte weg wirkungsvoll verhindern. In analoger Weise weisen die Führungen (128) der Hilfs- bzw. Steueranschlusselemente (32) ebenfalls Widerlager als Anschlag der gekrümmten Anschlagflächen (322) der Hilfs- bzw. Steueranschlusselemente (130) auf. Hierdurch ist auch eine Bewegung der Hilfs- bzw. Steueranschlusselemente (130) in Richtung von der Grundplatte weg wirkungsvoll verhindert.

Die Bewegung aller Anschlusselemente (30, 32) in Richtung auf die Grundplatte zu wird durch die beiden Arretierrahmen (130) wirkungsvoll verhindert. Diese Arretierrahmen rasten mit daran angeordneten Nasen in die zugeordneten Ausnehmungen (126) ein. Die Bewegung wird dadurch verhindert, dass die Anschlusslaschen (310, 320) aller Anschlusselemente auf der der Grundplatte abgewandten Seite der Arretierrahmen flächig aufliegen.

## Patentansprüche

1. Gehäuse (10) für Leistungshalbleitermodule mit Grundplatte (70) oder zur direkten Montage auf einem Kühlkörper (70), wobei das Gehäuse (10) mindestens ein elektrisch isolierendes Substrat (40) mit darauf angeordneten gegeneinander isolierten metallischen Verbindungsbahnen (41) mit darauf angeordneten Leistungshalbleiterbauelementen (50) umschließt und das Gehäuse (10) aus einer Mehrzahl von Teilen, mindestens einem Deckel (14) und mindestens einem rahmenartigen, die Seitenwände bildenden Gehäuseteil (12) besteht wobei der Gehäuseteil (12) seinerseits aus einem Hauptrahmen (120) besteht, wobei der Hauptrahmen (120) Führungen (122, 128) zur Aufnahme von Anschlusselementen (30, 32) mit substratseitig mindestens einer Anschlusslasche (310, 320) parallel zum Substrat verlaufend aufweist, diese Anschlusselemente (30, 32) mindestens eine Anschlagfläche (312, 322) aufweisen, die an Widerlagern (124) des Hauptrahmens (120) anliegt, um eine Bewegung des Anschlusselementes (30, 32) in Richtung von dem Substrat (40) weg zu verhindern **dadurch gekennzeichnet, dass** das Gehäuseteil (12) zusätzlich aus mindestens einem mehrstückig mit dem Hauptrahmen ausgebildeten Arretierrahmen (130) besteht, wobei der mindestens eine Arretierrahmen (130) derartig zum Hauptrahmen (120) angeordnet ist, dass der Arretierrahmen (130) zumindest teilweise auf den Anschlusslaschen (310, 320) der Anschlusselemente (30, 32) aufliegt, um eine Bewegung der Anschlusselemente in Richtung auf das Substrat (40) hin zu verhindern.

2. Schaltungsanordnung nach Anspruch 1, wobei
der Hauptrahmen (120) mit dem Arretierrahmen (130) mittels am Arretierrahmen angeordneter Nasen (132) und zugeordneten Ausnehmungen (126) des Hauptrahmens verbunden ist.

3. Schaltungsanordnung nach Anspruch 1, wobei
der Hauptrahmen (120) mit dem Arretierrahmen (130) mittels einer Klebeverbindung verbunden ist.

4. Schaltungsanordnung nach Anspruch 1, wobei
alle Teile (14, 120, 130) des Gehäuses (10) aus dem gleichen isolierenden Kunststoff bestehen.

5. Schaltungsanordnung nach Anspruch 1, wobei
die Anschlusselemente Lastanschlusselemente (30) und / oder Hilfs- / Steueranschlusselemente (32) sind.

6. Schaltungsanordnung nach Anspruch 1, wobei
der Arretierrahmen (130) den Rahmen zur Positionierung des Substrats (40) bildet.

## Claims

1. A housing (10) for power semiconductor modules with a base plate (70), or for direct mounting onto a cooling body (70), wherein
the housing (10) encloses at least one electrically insulating substrate (40) with insulated metallic connecting tracks (41) arranged opposite one another thereon, with power semiconductor components (50) arranged thereon, and the housing (10) consists of a plurality of parts, at least one cover (14), and at least one housing part (12) in the form of a frame, forming the sidewalls, wherein
the housing part (12) itself consists of a main frame (120), wherein
the main frame (120) has guides (122, 128) for the accommodation of connecting elements (30, 32), with at least one connecting tab (310, 320) on the substrate side running parallel to the substrate, these connecting elements (30, 32) have at lest one stop face (312, 322), which abuts against abutments (124) of the main frame (120) so as to prevent a movement of the connecting element (30, 32) in the direction away from the substrate (40),
**characterised in that** the housing part (12) additionally consists of a multi-part locking frame (130) designed with the main frame, wherein
the at least one locking frame (130) is arranged relative to the main frame (120) such that the locking frame (130) at least partially rests on the connecting tabs (310, 320) of the connecting elements (30, 32) so as to prevent a movement of the connecting elements in the direction towards the substrate (40).

2. The circuit arrangement in accordance with claim 1, wherein
the main frame (120) is connected with the locking frame (130) by means of lugs (132) arranged on the locking frame, and associated recesses (126) of the main frame.

3. The circuit arrangement in accordance with claim 1, wherein
the main frame (120) is connected with the locking frame (130) by means of an adhesive bond.

4. The circuit arrangement in accordance with claim 1, wherein
all parts (14, 120, 130) of the housing (10) consist of the same insulating plastic.

5. The circuit arrangement in accordance with claim 1, wherein
the connecting elements are load connecting elements (30) and/or ancillary control connecting elements (32).

6. The circuit arrangement in accordance with claim 1, wherein
the locking frame (130) forms the frame for purposes of positioning the substrate (40).

## Revendications

1. Boîtier (10) pour des modules à semi-conducteurs de puissance comprenant une plaque de base (70) ou pour le montage direct sur un corps réfrigérant (70), le boîtier (10) entourant au moins un substrat (40) électriquement isolant avec des bandes de liaison (41) métalliques, disposées dessus et isolées les unes par rapport aux autres avec des composants à semi-conducteurs de puissance (50) disposés dessus, et le boîtier (10) étant constitué d'une pluralité de pièces, d'au moins un couvercle (14) et d'au moins une partie de boîtier (12) de type cadre, formant les parois latérales, la partie de boîtier (12) étant constituée pour sa part d'un cadre principal (120), le cadre principal (120) présentant des guides (122, 128) pour le logement d'éléments de raccordement (30, 32) avec côté substrat au moins une patte de raccordement (310, 320) agencée parallèlement au substrat, ces éléments de raccordement (30, 32) présentant au moins une surface de butée (312, 322), qui s'applique sur des paliers de butée (124) du cadre principal (120), afin d'empêcher un déplacement de l'élément de raccordement (30, 32) dans la direction partant du substrat (40), **caractérisé en ce que** la partie de boîtier (12) comprend en outre au moins un cadre d'arrêt (130) conçu d'une seule pièce avec le cadre principal, au moins un cadre d'arrêt (130) étant disposé par rapport au cadre principal (120) de telle sorte que le cadre d'arrêt (130) repose au moins en partie sur les pattes de raccordement (310, 320) des éléments de raccordement (30, 32), afin d'empêcher un déplacement des éléments de raccordement en direction du substrat (40).

2. Agencement de circuit selon la revendication 1,
le cadre principal (120) étant relié au cadre d'arrêt (130) au moyen d'ergots (132) disposés sur le cadre d'arrêt et d'évidements (126) associés du cadre principal.

3. Agencement de circuit selon la revendication 1,
le cadre principal (120) étant relié au cadre d'arrêt (130) au moyen d'un assemblage collé.

4. Agencement de circuit selon la revendication 1,
toutes les parties (14, 120, 130) du boîtier (10) étant à base du même plastique isolant.

5. Agencement de circuit selon la revendication 1,
les éléments de raccordement étant des éléments de raccordement de charge (30) et/ou des éléments de raccordement auxiliaires/de raccordement de commande (32).

6. Agencement de circuit selon la revendication 1,
le cadre d'arrêt (130) formant le cadre pour le positionnement du substrat (40).
